## Europäisches Patentamt
## European Patent Office
## Office européen des brevets

(19)

(11) **EP 1 098 357 A1**

(12) **EUROPÄISCHE PATENTANMELDUNG**

(43) Veröffentlichungstag:
   **09.05.2001 Patentblatt 2001/19**

(51) Int Cl.[7]: **H01L 21/00, B23K 20/10, B23K 20/00**

(21) Anmeldenummer: **99810998.7**

(22) Anmeldetag: **02.11.1999**

(84) Benannte Vertragsstaaten:
   **AT BE CH CY DE DK ES FI FR GB GR IE IT LI LU MC NL PT SE**
   Benannte Erstreckungsstaaten:
   **AL LT LV MK RO SI**

(71) Anmelder: **ESEC SA**
   **6330 Cham (CH)**

(72) Erfinder: **Thürlemann, Silvan**
   **6314 Unterägeri (CH)**

(74) Vertreter: **Falk, Urs, Dr.**
   **Patentanwaltsbüro Dr. Urs Falk,**
   **Eichholzweg 9A**
   **6312 Steinhausen (CH)**

(54) **Bondkopf für einen Wire Bonder**

(57)    Ein Wire Bonder enthält einen Bondkopf (2), der einen Schlitten (3), einen um eine vertikale Achse (9) drehbaren Drehträger (4) und eine auf dem Drehträger (4) montierte Wippe (5) umfasst. Der Schlitten (3) ist in einer vorbestimmten horizontalen Richtung hin und her bewegbar und bewegt den Drehträger (4) mit. Vorzugsweise ist der Schlitten (3) auf einer horizontal angeordneten Gleitplatte (1) mittels eines mit Vakuum vorgespannten Luftlagers gelagert. Auch der Drehträger (4) ist vorzugsweise (1) mittels eines weiteren mit Vakuum vorgespannten Luftlagers auf der Gleitplatte gelagert. Für die Drehbewegung des Drehträgers (4) ist bevorzugt ein auf dem Schlitten (3) angeordneter Antrieb vorgesehen.

Fig 3

EP 1 098 357 A1

## Beschreibung

Die Erfindung betrifft einen Bondkopf für einen Wire Bonder.

Wire Bonder werden zur Herstellung von Drahtverbindungen zwischen einem Halbleiterchip und einem Substrat eingesetzt Die meisten der heutzutage auf dem Markt erhältlichen Wire Bonder bewegen den Bondkopf in der horizontalen xy-Ebene mittels zweier orthogonal angeordneter Antriebe. Ein Beispiel eines solchen Antriebssystems ist beispielsweise offenbart in der Patentschrift EP 317 787. Dieses Antriebssystem benutzt zudem mittels Vakuum vorgespannte Luftlager. Ein erheblicher Nachteil dieser bekannten Wire Bonder besteht darin, dass beim Fahren des Bondkopfes an eine neue Position relativ grosse Massen beschleunigt werden müssen. Dies erfordert kräftige Antriebssysteme und robuste Lager. Ein weiterer Nachteil besteht darin, dass bei der Beschleunigung des Bondkopfes je nach der Position des Bondkopfes relativ grosse Drehmomente auftreten, die grosse Anforderungen an die Lagerung des Bondkopfes stellen. Dies setzt den maximal möglichen Beschleunigungswerten und damit dem Durchsatz des Wire Bonders Grenzen.

Aus der Patentschrift US 5 330 089 ist ein Wire Bonder bekannt, bei dem die Bewegung des Bondkopfes mit einem polaren Antriebssystem erfolgt Auch bei diesem Antriebssystem müssen relativ grosse Massen beschleunigt werden. Die bei der Drehbewegung vom Motor zu beschleunigende Last hängt zudem von der Lage der Last bezüglich der Linearachse ab, was einerseits die Regelung der Bewegungen des Bondkopfes erschwert und andererseits den maximal möglichen Beschleunigungswerten Grenzen setzt

Der Erfindung liegt die Aufgabe zugrunde, einen neuen Wire Bonder zu entwickeln, dessen Bondkopf markant höhere Beschleunigungen erträgt.

Die genannte Aufgabe wird erfindungsgemäss gelöst durch die Merkmale des Anspruchs 1.

Nachfolgend werden Ausführungsbeispiele der Erfindung anhand der Zeichnung näher erläutert.

Es zeigen:

Fig. 1 einen Wire Bonder in perspektivischer Ansicht,
Fig. 2 ein Koordinatendiagramm, und
Fig. 3 einen weiteren Wire Bonder in perspektivischer Ansicht.

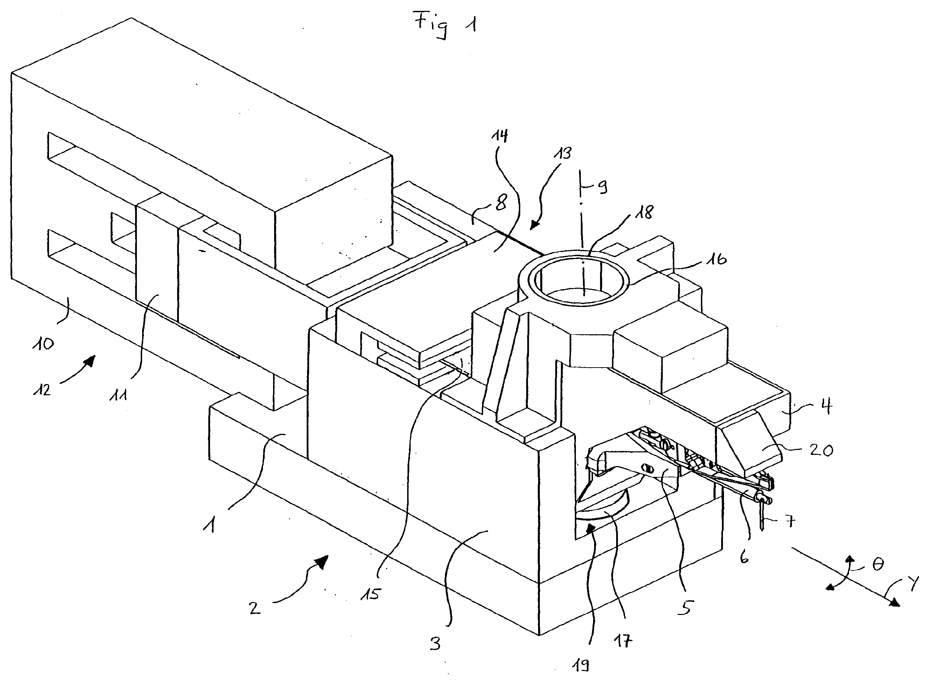

Die Fig. 1 zeigt einen Wire Bonder zum Herstellen von Drahtverbindungen mit einer horizontal ausgerichteten Gleitplatte 1 und einem auf der Gleitplatte 1 gleitenden Bondkopf 2. Der Bondkopf2 umfasst einen Schlitten 3, einen Drehträger 4 und eine Wippe 5. An der Wippe 5 ist ein mit Ultraschall beaufschlagbares Horn 6 befestigt, an dessen Spitze eine den Draht führende Kapillare 7 eingespannt ist. Der Schlitten 3 ist mittels eines ersten mit Vakuum vorgespannten Luftlagers auf der Gleitplatte 1 und mittels eines zweiten mit Vakuum vorgespannten Luftlagers an einem Lagerelement 8 gelagert, das parallel zu einer als y-Richtung bezeichneten Richtung ausgerichtet ist Die Vorspannung der beiden Luftlager mit Vakuum bewirkt, dass der Schlitten 3 nicht nur gelagert ist, sondern auch mit vorbestimmter Kraft gegen die Gleitplatte 1 bzw. das Lagerelement 8 gezogen wird: Die Bewegung des Schlittens 3 ist nur in der y-Richtung möglich und erfolgt praktisch reibungsfrei.

Der Schlitten 3 bewegt den Drehträger 4 in der y-Richtung hin und her. Der Drehträger 4 ist um eine vertikale Achse 9, die sich mit dem Schlitten 3 in y-Richtung mitbewegt, drehbar im Schlitten 3 gelagert, wobei das Lager bevorzugt als Luftlager ausgebildet ist: Weil das Luftpolster unvermeidliche lokale Abweichungen von der Idealform der das Luftlager begrenzenden Flächen automatisch ausgleicht, ist die Lage der Achse 9 bezüglich des Schlittens 3 sehr stabil. Der Drehträger 4 ist bezüglich der y-Richtung um einen Winkel $\theta$ von etwa $\pm 15°$ drehbar.

Vorzugsweise ist der Drehträger 4 mittels eines dritten mit Vakuum vorgespannten Luftlagers direkt auf der Gleitplatte 1 gelagert, so dass der Schlitten 3 nur die Führung des Drehträgers 4 in der y-Richtung, nicht aber die vertikale Lagerung des Drehträgers 4 übernimmt. Allfällige vertikale Schwingungen des Schlittens 3 übertragen sich somit nicht auf die Kapillare 7.

Die um eine horizontale Achse drehbare Wippe 5 ist auf dem Drehträger 4 montiert Der Schlitten 3 und der Drehträger 4 ermöglichen die Bewegung der Kapillare 7 in einem vorbestimmten Gebiet innerhalb der horizontalen Ebene. Die Wippe 5 ermöglicht die Bewegung der Kapillare 7 in vertikaler Richtung.

Ein aus einem ortsfest angeordneten Stator 10 und einer beweglichen Spule 11 gebildeter Linearmotor 12 dient als Antrieb für den Schlitten 3. Die Drehbewegung des Drehträgers 4 um die vertikale Achse 9 erfolgt mittels eines zweiten Linearmotors 13, dessen Stator 14 auf dem Schlitten 3 und dessen Spule 15 am Drehträger 4 befestigt ist Da der Linearmotor 13 auf dem Schlitten 3 befestigt ist und sich mit diesem mitbewegt, kann die Spule 15 bezüglich der vertikalen Achse 9 problemlos gegenüber der Kapillare 7 angeordnet werden, so dass der Drehträger 4 mit den von ihm mitgeführten Elementen bezüglich der vertikalen Achse 9 ausgewuchtet ist Der Abstand der Spule 15 von der vertikalen Achse 9 ist mit Vorteil so gewählt und der zugehörige Stator 14 so angeordnet, dass der Schwerpunkt des Drehträgers 4 und der von ihm mitgeführten Elemente auf der vertikalen Achse 9 oder möglichst nahe bei der vertikalen Achse 9 liegt. Bei der Drehung des Drehträgers 4 bleibt die Belastung der Lager daher gering.

Für die horizontale Lagerung des Drehträgers 4 im Schlitten 3 sind zwei in vertikaler Richtung getrennte Luftlager vorgesehen, die unten und oben am Schlitten 3 angeordnet sind. Sowohl der Einsatz eines Luftlagers an sich als auch der Einsatz von zwei Luftlagern, die eine vorbestimmte Distanz auseinander liegen, tragen zur Stabilität der Lage der vertikalen Achse 9 bezüglich des Schlittens 3 bei. Zur Bildung der beiden räumlich getrennten Luftlager ist der Drehträger 4 mit zwei Zylindern 16 und 17 versehen, die in Bohrungen 18 bzw. 19 des Schlittens 3 eingreifen. Die beiden Zylinder 16 und 17 weisen je zwei Reihen mit Bohrungen auf, durch die im Innern der Zylinder 16 und 17 zugeführte Luft nach aussen gegen den inneren Rand der Bohrung 18 bzw. 19 strömt und die praktisch reibungsfreie und spielfreie Lagerung des Drehträgers 4 im Schlitten 3 gewährleistet.

Das mit Vakuum vorgespannte dritte Luftlager, das der vertikalen Lagerung des Drehträgers 4 dient, ist vorzugsweise direkt im unteren Zylinder 17 integriert. Die für die Vorspannung mit Vakuum zur Verfügung stehende Fläche und damit die auf den Zylinder 17 in vertikaler Richtung maximal mögliche Zugkraft auf den Drehträger 4 nimmt quadratisch zu mit dem Durchmesser des unteren Zylinders 17. Die Steifigkeit des Drehträgers 4 kann somit über die Wahl dieses Durchmessers beeinflusst werden. Die Steifigkeit des Drehträgers 4 kann bei Bedarf auch dadurch vergrössert werden, dass oberhalb des Drehträgers 4 parallel zur Gleitplatte 1 eine zweite Gleitplatte angeordnet wird, wobei dann der Drehträger 4 über Luftlager zwischen den Gleitplatten gelagert wird.

Über zwei am Drehträger 4 befestigte Umlenkspiegel, von denen der eine 20 oberhalb der Spitze des Horns 6 und der andere (nicht sichtbar) zentriert bezüglich der vertikalen Aches 9 angeordnet ist, wird das Bild der Bondfläche auf eine am Schlitten 3 befestigte, auf der vertikalen Achse 9 zentrierte (nicht dargestellte) Kamera projiziert. Der Drehträger 4 und alle Elemente, die auf dem Drehträger 4 angeordnet sind, wie z.B. Wippe 5, Spule 15, Kamera, Spiegel, Beleuchtungselemente, etc. sind in ihrem Zusammenwirken derart ausgestaltet und angeordnet, dass der Massenschwerpunkt des Drehträgers 4 möglichst nahe bei der vertikalen Achse 9 liegt.

Einzelheiten über die Ausgestaltung eines mit Vakuum vorgespannten Luftlagers können der europäischen Patentschrift EP 317 787 entnommen werden.

Der erfindungsgemässe Wire Bonder weist die folgenden Vorteile auf:

- Kompakter Aufbau.
- Die Belastung des Lagerelementes 8 bei Beschleunigung des Schlittens 3 durch den Linearmotor 12 ist sehr gering im Vergleich zu der Belastung der Lager des in der EP 317 787 offenbarten Wire Bonders. Da die Antriebskraft ganz oder zumindest nahezu auf den Schwerpunkt des Bondkopfes 2 zu oder von diesem weg gerichtet ist, treten keine oder im Vergleich markant geringere Drehmomente auf, die das Lagerelement 8 belasten.
- Die Drehbewegung des Drehträgers 4 um die vertikale Achse 9 kann mit sehr hoher Beschleunigung erfolgen, da die zu beschleunigende Masse vergleichsweise gering ist Beim vorgestellten Ausführungsbeispiel muss der Linearmotor 13 für den Antrieb des Drehträgers 4 eine etwa um den Faktor 10 geringere Kraft aufbringen können als der den Schlitten 3 antreibende Linearmotor 12 und wird dementsprechend deutlich kleiner und billiger. Auch die den Linearmotor 13 speisende Energiequelle kann dadurch einfacher ausfallen. Insgesamt sind in der Horizontalebene markant höhere Beschleunigungen des Bondkopfes 2 als beim Stand der Technik möglich.
- Die verringerte Belastung der Lager führt in der Folge zu einer deutlich verringerten Schwingungsneigung des Bondkopfes 2 und zu einem schnelleren Abklingen allfälliger Schwingungen. Damit wird der Bondprozess schneller.
- Zur Reduktion der zu beschleunigenden Massen tragen auch die selbst gewichtslosen Luftlager bei.
- Die direkte Lagerung des Drehträgers 4 auf der Gleitplatte 1 bietet den Vorteil, dass sich allfällige vertikale Schwingungen des Schlittens 3 nicht auf den Bondkopf 2 übertragen.

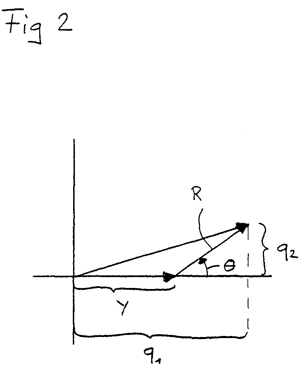

Die Position der Kapillare ist eindeutig bestimmt durch Angabe der y-Koordinate der vertikalen Achse 9, die mit dem Schlitten 3 in y-Richtung mitbewegt wird, und des Winkels $\theta$ des Drehträgers 4, der die Drehlage des Drehträgers 4 bezüglich der y-Richtung bezeichnet. Die Umrechnung der Position der Kapillare in kartesischen Koordinaten $(q_1, q_2)$ in die Position der Kapillare in die Koordinaten $(y, \theta)$ erfolgt, wie aus der Fig. 2 ersichtlich ist, gemäss den Gleichungen:

$$q_1 = y + R^* \cos\theta,$$

$$q_2 = R^* \sin\theta$$

wobei die Grösse R den Abstand der Spitze der Kapillare zur vertikalen Achse 9 bezeichnet.

Für die Erfassung der Koordinaten $(y, \theta)$ sind zwei Positionsmesssysteme vorgesehen, die in an sich bekannter Weise aus je einem Metallmassstab und einem dazugehörigen Lesekopf bestehen. Der Metallmassstab für die Messung des Winkels $\theta$ ist auf einer zum oberen Zylinder 16 konzentrischen Fläche aufgeklebt. Beim Anfahren einer neuen Position kann so bei der Regelung der durch die Linearmotoren 12 und 13 fliessenden Ströme die aktuelle Ist-Position mitberücksichtigt werden.

Anstelle der Gleitplatte 1 und des Lagerelementes 8 kann auch ein konventionelles Lager für die Führung des Schlittens 3 in y-Richtung vorgesehen sein, z.B. ein in y-Richtung beweglicher Tisch. Auch könnte der Drehträger 4 mittels eines Kugellagers oder eines Festkörpergelenkes im Schlitten 3 gelagert sein.

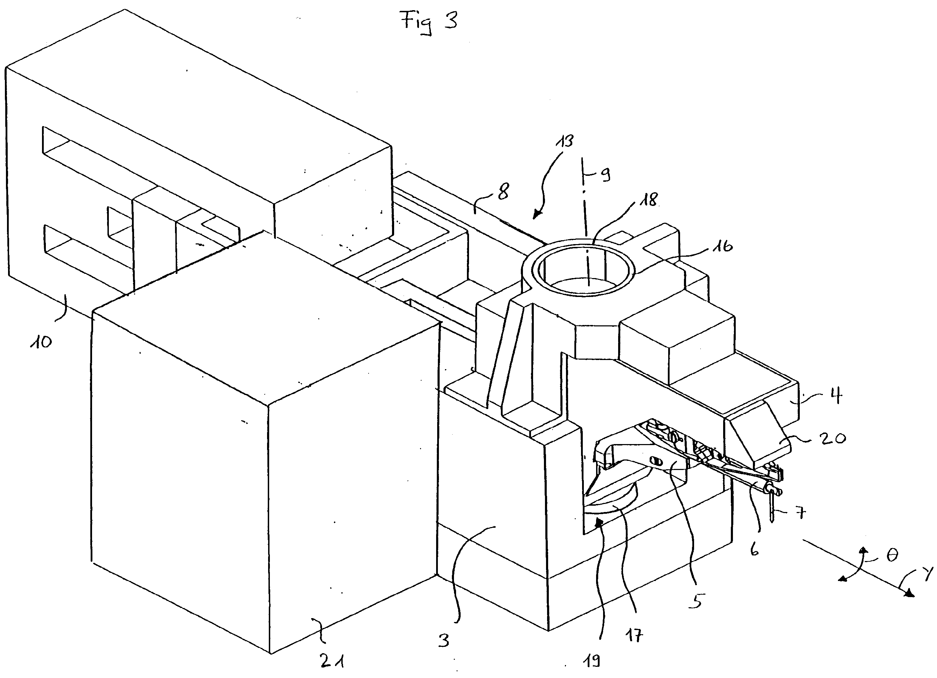

Die Fig. 3 zeigt ein Ausführungsbeispiel des Wire Bonders, bei dem der Antrieb für die Drehbewegung des Drehträgers 4 ortsfest angeordnet ist Als Antrieb ist ein Linearmotor 21 vorgesehen, dessen Stator ortsfest ist, während die Spule am Drehträger 4 befestigt ist

**Patentansprüche**

1. Wire Bonder mit einem Bondkopf, der einen Schlitten und einen um eine vertikale Achse drehbaren Drehträger umfasst, **dadurch gekennzeichnet, dass** der Schlitten (3) in einer vorbestimmten horizontalen Richtung hin und her bewegbar ist und dass der Schlitten (3) den Drehträger (4) entlang der vorbestimmten horizontalen Richtung mitbewegt.

2. Wire Bonder nach Anspruch 1, **dadurch gekennzeichnet, dass** der Schlitten (3) auf einer horizontal angeordneten Gleitplatte (1) mittels eines mit Vakuum vorgespannten Luftlagers gelagert ist.

3. Wire Bonder nach Anspruch 2, **dadurch gekennzeichnet, dass** der Drehträger (4) auf der horizontal angeordneten Gleitplatte (1) mittels eines weiteren mit Vakuum vorgespannten Luftlagers gelagert ist.

4. Wire Bonder nach einem der Ansprüche 1 bis 3, **dadurch gekennzeichnet, dass** für die Lagerung des Drehträgers (4) im Schlitten (3) zwei durch einen Abstand getrennte Lager vorgesehen sind.

5. Wire Bonder nach einem der Ansprüche 1 bis 4, **dadurch gekennzeichnet, dass** der Drehträger (4) für die Drehung um die vertikale Achse (9) mit Luft im Schlitten (3) gelagert ist

6. Wire Bonder nach einem der Ansprüche 1 bis 5, **dadurch gekennzeichnet, dass** für die Drehbewegung des Drehträgers (4) ein auf dem Schlitten (3) angeordneter Antrieb vorgesehen ist.

7. Wire Bonder nach einem der Ansprüche 1 bis 6, **dadurch gekennzeichnet, dass** auf dem Drehträger (4) eine um eine horizontale Achse drehbare Wippe (5) vorgesehen ist.

Fig 1

EP 1 098 357 A1

Fig 2

Fig 3

EP 1 098 357 A1

**Europäisches Patentamt**

**EUROPÄISCHER RECHERCHENBERICHT**

Nummer der Anmeldung

EP 99 81 0998

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X<br>A | EP 0 541 116 A (MATSUSHITA ELECTRIC IND CO LTD) 12. Mai 1993 (1993-05-12)<br>* Spalte 8, Zeile 24 - Zeile 34 *<br>* Abbildung 3 * | 1,6,7<br><br>2-5 | H01L21/00<br>B23K20/10<br>B23K20/00 |
| D,X | US 5 330 089 A (ORCUTT JOHN W ET AL) 19. Juli 1994 (1994-07-19)<br>* das ganze Dokument * | 1-7 | |
| D,A | EP 0 317 787 A (ESEC SA) 31. Mai 1989 (1989-05-31) | 1-7 | |

RECHERCHIERTE SACHGEBIETE (Int.Cl.7)

H01L
B23K

Der vorliegende Recherchenbericht wurde für alle Patentansprüche erstellt

| Recherchenort | Abschlußdatum der Recherche | Prüfer |
|---|---|---|
| DEN HAAG | 9. Mai 2000 | Haegeman, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 99 81 0998

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-05-2000

| Im Recherchenbericht angeführtes Patentdokument | | Datum der Veröffentlichung | Mitglied(er) der Patentfamilie | | | Datum der Veröffentlichung |
|---|---|---|---|---|---|---|
| EP 0541116 | A | 12-05-1993 | JP | 2558976 | B | 27-11-1996 |
|  |  |  | JP | 6013427 | A | 21-01-1994 |
|  |  |  | DE | 69217448 | D | 27-03-1997 |
|  |  |  | DE | 69217448 | T | 28-05-1997 |
|  |  |  | KR | 9606967 | B | 25-05-1996 |
|  |  |  | US | 5316204 | A | 31-05-1994 |
| US 5330089 | A | 19-07-1994 | US | 5556022 | A | 17-09-1996 |
|  |  |  | JP | 5235077 | A | 10-09-1993 |
| EP 0317787 | A | 31-05-1989 | AT | 102410 | T | 15-03-1994 |
|  |  |  | DE | 3888102 | D | 07-04-1994 |
|  |  |  | HK | 1000178 | A | 16-01-1998 |
|  |  |  | JP | 1216734 | A | 30-08-1989 |
|  |  |  | US | 5114302 | A | 19-05-1992 |

EPO FORM P0461

Für nähere Einzelheiten zu diesem Anhang : siehe Amtsblatt des Europäischen Patentamts, Nr.12/82